# EUROPÄISCHE PATENTSCHRIFT

(11) **EP 3 684 967 B1**
(45) Veröffentlichungstag und Bekanntmachung des Hinweises auf die Patenterteilung: **02.03.2022**
(21) Anmeldenummer: 17818075.8
(22) Anmeldetag: 05.12.2017
(51) Int. Cl.: C30B 29/06, C01B 33/035, C30B 35/00, G01K 1/143

(54) **VERFAHREN ZUR BESTIMMUNG EINER OBERFLÄCHENTEMPERATUR**
METHOD FOR DETERMINING A SURFACE TEMPERATURE
PROCÉDÉ POUR LA DÉTERMINATION D'UNE TEMPÉRATURE DE SURFACE

(43) Veröffentlichungstag der Anmeldung: 29.07.2020
(73) Patentinhaber: Wacker Chemie AG, 81737 München (DE)
(72) Erfinder: SEIFARTH, Olaf, 84489 Burghausen (DE); SOMMERAUER, Stefan, 5121 Ostermiething (AT); WENZEIS, Markus, 84329 Wurmannsquick (DE)
(74) Vertreter: Belz, Ferdinand
(86) Internationale Anmeldenummer: PCT/EP2017/081551
(87) Internationale Veröffentlichungsnummer: WO 2019/110091

(56) Entgegenhaltungen:
- WO-A2-2010/086363
- CN-B- 102 795 627
- DE-A1- 2 518 853

## Beschreibung

Die Erfindung betrifft ein Verfahren zur Bestimmung einer Oberflächentemperatur von mindestens einem Siliciumstab in einem mehrere Siliciumstäbe enthaltenden chemischen Gasphasenabscheidungsreaktor während eines Abscheidungsprozesses. Ferner betrifft die Erfindung einen Reaktor zur Abscheidung von polykristallinem Silicium, der eine Anordnung zur Bestimmung einer Oberflächentemperatur umfasst.

Polykristallines Silicium (Polysilicium) dient als Ausgangsmaterial bei der Herstellung von einkristallinem Silicium, beispielsweise mittels Tiegelziehen (Czochralski-Verfahren) oder mittels Zonenschmelzen (Floatzone-Verfahren). Das einkristalline Silicium kann in Scheiben (Wafer) zersägt und nach einer Vielzahl weiterer Bearbeitungsschritte in der Halbleiterindustrie zur Fertigung von elektronischen Bauelementen (Chips) verwendet werden.

Ferner wird Polysilicium zur Herstellung von multikristallinem Silicium, beispielsweise mittels Blockgussverfahren, benötigt. Das in Form eines Blocks erhaltene multikristalline Silicium kann zur Fertigung von Solarzellen eingesetzt werden. Dazu werden die Siliciumblöcke in der Regel zu rechteckigen Wafern zersägt.

Polysilicium wird meist mittels des Siemens-Prozesses - ein chemischer Gasphasenabscheidungsprozess - hergestellt. Dabei werden in einem glockenförmigen Reaktor (Siemens-Reaktor) dünne Filamentstäbe (Dünnstäbe) aus Silicium durch direkten Stromdurchgang erhitzt und ein Reaktionsgas enthaltend eine siliciumhaltige Komponente und Wasserstoff eingeleitet. Die siliciumhaltige Komponente ist in der Regel Monosilan (SiH₄) oder ein Halogensilan der allgemeinen Zusammensetzung SiHₙX₄₋ₙ (n = 0, 1, 2, 3; X = Cl, Br, I). Üblicherweise handelt es sich um ein Chlorsilan oder Chlorsilangemisch, meist um Trichlorsilan (SiHCl₃, TCS). Überwiegend wird SiH₄ oder SiHCl₃ im Gemisch mit Wasserstoff eingesetzt. Der Aufbau eines typischen Siemens-Reaktors ist beispielsweise in der EP 2 077 252 A2 beschrieben.

Der Reaktorboden ist generell mit Elektroden versehen, welche die Dünnstäbe aufnehmen. Üblicherweise werden jeweils zwei Dünnstäbe mit einer Brücke zu einem Dünnstabpaar verbunden, das über die Elektroden einen Stromkreis bildet (ein Dünnstabpaar hat die Form eines umgedrehten U). Die Oberflächentemperatur der Filamentstäbe beträgt üblicherweise mehr als 1000°C. Bei diesen Temperaturen zersetzt sich die siliciumhaltige Komponente des Reaktionsgases und elementares Silicium scheidet sich aus der Gasphase als Polysilicium auf der Staboberfläche ab (chemische Gasphasenabscheidung CVD; engl.: chemical vapour deposition). Dadurch nimmt der Durchmesser der Dünnstäbe zu. Nach dem Erreichen eines vorgegebenen Durchmessers wird die Abscheidung üblicherweise gestoppt und die erhaltenen U-förmigen Siliciumstäbe ausgebaut. Nach dem Entfernen der Brücke werden annähernd zylinderförmige Siliciumstäbe erhalten.

Die Oberflächentemperatur der Siliciumstäbe ist eine wichtige Einflussgröße, die während der Abscheidung typischerweise kontrolliert und durch Variation des Stromdurchgangs angepasst werden kann. Grundsätzlich nimmt der Wärmefluss, der die Siliciumstäbe verlässt, mit der Abscheidezeit zu, da der Durchmesser und damit die Oberfläche der Stäbe wächst. Während der Abscheidung ist also üblicherweise eine Anpassung der Stromstärke erforderlich. Zu hohe Oberflächentemperaturen führen grundsätzlich zu einer übermäßigen Bildung von Siliciumstaub, während zu niedrige Oberflächentemperaturen zu einer verlangsamten Abscheidung oder gar keiner Abscheidung mehr führen. Daneben bestimmt die Oberflächentemperatur die Oberflächenbeschaffenheit und damit die Qualität der Siliciumstäbe. Höhere Temperaturen führen zwar generell zu einem schnelleren Anwachsen der Siliciumstäbe, allerdings nimmt die Ausprägung einer unebenen Oberfläche mit steigender Temperatur zu.

Eine bekannte Methode zur Messung der Oberflächentemperatur eines Siliciumstabes ist die Verwendung von Pyrometern, beispielsweise Strahlungspyrometern. Generell messen Pyrometer die Temperatur eines Messpunkts auf einer Oberfläche anhand der Strahlungsintensität, die bei einer bestimmten Wellenlänge oder einem bestimmten Wellenlängenbereich emittiert wird. Aufgrund der Hitze im Inneren des Reaktors erfolgt die Messung grundsätzlich von außerhalb des Reaktors, wobei die Strahlung durch ein in der Reaktorwand angebrachtes Sichtfenster detektiert wird. Um einen ungestörten Strahlungsdurchgang zu gewährleisten, ist das Sichtfenster in der Regel mit speziellen Optiken ausgestattet.

Problematisch bei der Bestimmung der Temperatur nur eines Messpunkts ist generell die Oberflächenbeschaffenheit des Polysiliciumstabes. Optimale Messergebnisse können nur auf einer ebenen Oberfläche erzielt werden. In der Realität kann die Oberfläche eines Siliciumstabes allerdings Furchen und Erhebungen aufweisen, die sich hinsichtlich ihrer Oberflächentemperatur stark unterscheiden können.

Aus der EP 2 391 581 B1 ist ein Verfahren zur Messung des Durchmessers und der Oberflächentemperatur eines Siliciumstabes bekannt. Dabei wird mittels eines Pyrometers, das horizontal um eine Drehachse, die parallel zur Längsachse des Siliciumstabes verläuft, schwenkbar ist, eine Temperaturmessung über die Zeit und gleichzeitig eine Messung des Dickenwachstums durch horizontales Schwenken durchgeführt. Es werden also mehrere Temperaturmessungen auf einer horizontalen Linie vorgenommen.

Bei schwenkbaren Pyrometern können gegebenenfalls weitere Siliciumstäbe innerhalb des Reaktors in den optischen Weg zwischen Pyrometer und zu vermessenden Siliciumstab gelangen. Ferner kann es zu einer Detektion der inneren Reaktorwandtemperatur kommen. Um derartige Störsignale auszublenden sind Prozeduren erforderlich, die von vorbestimmten Temperaturschwellwerten abhängen und darüber entscheiden, ob die Temperatur auf dem zu vermessenden Siliciumstab oder neben diesem detektiert wird. Solche Schwellwertverfahren sind anfällig gegenüber Störungen. Beispielsweise können Fluktuationen der Gasströme zu Fehlmessungen führen. Ferner ist es in der Regel schwierig Temperaturen zu unterscheiden, die von zwei übereinander gelagerten Stäben stammen, über die geschwenkt wird. Der ermittelte Durchmesser kann so verfälscht werden. Erschwerend kommt hinzu, dass während der Abscheidung der Durchmesser der Polysiliciumstäbe zunimmt und sich damit die für die Temperaturmessung charakteristische Fläche verändert. Außerdem verkürzt sich der Abstand zwischen dem Pyrometer und der Staboberfläche, was mit einer Veränderung des Fokus einhergeht. Eine weitere Herausforderung bei der Oberflächentemperaturmessung sind die Seitenbereiche des Siliciumstabes. In diesen Bereichen ist üblicherweise eine zuverlässige Temperaturerfassung unmöglich, da die emittierte Strahlung in diesen Bereichen nur zu einem kleinen Teil auf den Detektor eines Pyrometers trifft.

Aus der EP 2 732 067 B1 ist ein Verfahren zur Überwachung der Oberflächentemperatur eines Siliciumstabes in einem CVD-Reaktor bekannt, bei welchem mit einem Bilderfassungsgerät (Digitalkamera oder CCD Sensor) ein Bild des Reaktorinnenraums durch ein Sichtfenster aufgenommen wird. Die Temperatur wird durch eine Pixelanalyse in einer konstant großen Zielfläche des Bildes bestimmt. Gegebenenfalls wird die Strahlungsintensität und damit die Temperatur des Siliciumstabes durch Vergleichen des Bildes mit einer Strahlungsintensität eines Referenzbildes ermittelt. Ferner lassen sich anhand der Pixelanalyse (Übergang von hellen zu dunklen Pixeln) die Außenkanten eines Siliciumstabes bestimmen. Daraus kann der Durchmesser berechnet und die Position der Zielfläche festgelegt werden.

Aus der CN 102 795 627 B ist ein Verfahren zur Herstellung von Polysilicium bekannt, bei dem mit einer CCD-Kamera sowohl der Durchmesser als auch die Temperatur eines Stabes bestimmt werden. Dies erfolgt durch Kopplung der Kamera an ein Softwaremodul zur Durchmesserbestimmung und eines zur Temperaturbestimmung.

Bei der Bestimmung der Oberflächentemperatur und des Stabdurchmessers mit nur einem Bilderfassungsgerät kann es insbesondere dann zu Problemen kommen, wenn sich zwei Siliciumstäbe überlagern. Da die Stäbe üblicherweise in etwa dieselbe Temperatur aufweisen, können diese unter Umständen als ein Stab erfasst werden, wodurch sich ein zu großer Durchmesser errechnet. Wird nun der Bereich, in welchem die Temperatur analysiert wird, in Abhängigkeit des Durchmessers positioniert, können gegebenenfalls die gekrümmten Stabkanten im Bereich der Überlagerung erfasst werden, wodurch die Temperaturanalyse verfälscht wird. Daneben berücksichtigt ein flächenmäßig konstant großer Messbereich nicht die mit steigendem Siliciumstabdurchmesser kleiner werdende Krümmung der Stäbe.

Der Erfindung lag die Aufgabe zugrunde, während des Betriebs eines Abscheidungsreaktors ein Verfahren zur Messung der Oberflächentemperatur von Siliciumstäben bereitzustellen, das die aus dem Stand der Technik bekannten Nachteile überwindet.

Diese Aufgabe wird gelöst durch ein Verfahren zur Bestimmung einer Oberflächentemperatur von mindestens einem Siliciumstab in einem chemischen Gasphasenabscheidungsreaktor, enthaltend mehrere Siliciumstäbe, während eines Abscheidungsprozesses, bei dem eine Messvorrichtung A in einer auf dem Siliciumstab angeordneten Messfläche die Oberflächentemperatur bestimmt und eine separate Messvorrichtung B kontinuierlich oder diskontinuierlich mindestens einen Durchmesser des Siliciumstabes und mindestens einen Durchmesser zumindest eines anderen in dem Reaktor angeordneten Siliciumstabes ermittelt, wobei die Messvorrichtungen A und B an verschiedenen Positionen jeweils vor einem Sichtfenster oder vor einem gemeinsamen Sichtfenster außerhalb des Reaktors angeordnet sind. Die Größe und/oder die Position der Messfläche auf dem Siliciumstab wird dabei in Abhängigkeit des oder der ermittelten Durchmesser angepasst bzw. definiert.

Das Verfahren umfasst vorzugsweise die folgenden Schritte:
a) Ermitteln von jeweils mindestens einem Durchmesser des Siliciumstabes und von zumindest einem anderen Siliciumstab mit der Messvorrichtung B;
b) Definieren der Größe und/oder der Position der auf dem Siliciumstab angeordneten Messfläche in Abhängigkeit des in Schritt a) ermittelten Durchmessers;
c) Bestimmen der Oberflächentemperatur innerhalb der Messfläche mit der Messvorrichtung A;
d) Kontinuierliches oder diskontinuierliches Wiederholen der Schritte a), b) und c), wobei eine kontinuierliche oder diskontinuierliche Anpassung der Größe und/oder der Position der Messfläche an den Durchmesser des Siliciumstabes erfolgt.

Die Verwendung von zwei separaten Messvorrichtungen A und B ermöglicht eine besonders störungsfreie Bestimmung des Siliciumstabdurchmessers und seiner Oberflächentemperatur. Vorteilhafterweise kann die Anordnung der Messvorrichtungen derart erfolgen, dass die Problematik einer Überlagerung des jeweiligen Messbereichs durch andere Siliciumstäbe ausgeschlossen werden kann. Die dynamische Anpassung der Größe der Messfläche an den unmittelbar ermittelten Stabdurchmesser trägt der sich mit steigendem Durchmesser veränderten Krümmung des Stabes Rechnung. Ferner kann die Messfläche auf diese Weise besonders groß gehalten werden. Dadurch können durch die Oberflächenstruktur bedingte Temperaturunterschiede auf der Staboberfläche besser kompensiert werden, so dass es zu keiner Verfälschung des Messergebnisses kommt. Durch die dynamische Anpassung der Position der Messfläche auf dem Siliciumstab kann sichergestellt werden, dass die Messfläche einen konstanten Abstand zu einer oder beiden Kanten des Siliciumstabes einhält. Insbesondere kann die Messfläche mittig zwischen den Stabkanten positioniert werden, so dass die für gewöhnlich zu ungenauen Messergebnissen führenden Seitenbereiche ausgespart bleiben.

Bei dem Gasphasenabscheidungsreaktor handelt es sich insbesondere um einen Siemens-reaktor. Die Anzahl der im Reaktor angeordneten Siliciumstäbe bzw. Siliciumstabpaare ist für die Ausführung des erfindungsgemäßen Verfahrens generell unerheblich. Typische Beispiele für die Anzahl von Siliciumstäben in einem Reaktor sind 36 (18 Stabpaare), 48 (24 Stabpaare) oder 54 (27 Stabpaare). Die Siliciumstäbe können in guter Näherung als zylinderförmig angesehen werden. Die Dünnstäbe können ebenfalls zylindrisch ausgebildet sein, möglich sind allerdings auch andere Geometrien. Ferner kann davon ausgegangen werden, dass sowohl die Oberflächentemperatur als auch der Durchmesser aller Siliciumstäbe im Reaktor im Wesentlichen gleich ist, insbesondere dann, wenn die entsprechenden Messwerte bei gleicher Stabhöhe, beispielsweise der Stabmitte, verglichen werden. Diese Näherung ist gerechtfertigt, da moderne Siemens-Reaktoren dafür ausgelegt sind, eine möglichst homogene Abscheidung zu gewährleisten, d.h. Siliciumstäbe gleicher Qualität und Form zu generieren. Dies wird durch einen homogenen Gasfluss innerhalb des Reaktors erreicht und insbesondere durch eine im Wesentlichen symmetrische Anordnung der Stäbe. An welchem Stab oder Stäben die Temperatur- und Durchmesserbestimmung durchgeführt wird ist daher von der Anzahl in einem Reaktor angeordneter Siliciumstäbe generell unabhängig. Zudem hat eine dynamisch an das Wachstum der Siliciumstäbe angepasste Temperaturmessfläche den Vorteil, gegebenenfalls auftretende Temperaturunterschiede herauszumitteln.

Die Bestimmung der Oberflächentemperatur und des Durchmessers erfolgt von außerhalb des Reaktors durch ein Sichtfenster. Die Messvorrichtungen A und B sind dabei insbesondere an verschiedenen Positionen jeweils vor einem Sichtfenster angeordnet. Bevorzugt befinden sich die Messvorrichtungen allerdings auf gleicher Höhe, wobei es unwesentlich ist, ob sich die Messvorrichtungen beispielsweise auf Höhe der Stabmitte oder auf Höhe des oberen oder unteren Stabdrittels befinden. Beispielsweise kann die Messvorrichtung A auf einer der Messvorrichtung B gegenüberliegenden Seite des üblicherweise glockenförmigen Reaktors angeordnet sein. Vorzugsweise sind die Messvorrichtungen nebeneinander (in Umfangsrichtung des Reaktors) vor jeweils einem Sichtfenster positioniert. Sie können auch nebeneinander oder übereinander vor einem gemeinsamen Sichtfenster positioniert sein.

Unter einem kontinuierlichen Wiederholen soll insbesondere verstanden werden, dass die Erfassung des Durchmessers und damit die dynamische Anpassung der Messfläche und/oder deren Position in Echtzeit während der gesamten Abscheidung erfolgt. Bei einem diskontinuierlichen Wiederholen erfolgt die Erfassung in festgelegten Intervallen, beispielsweise minuten- oder stundenweise.

Die Messvorrichtung B umfasst vorzugsweise eine Kamera, insbesondere Digitalkamera oder CCD-Kamera. Bevorzugt handelt es sich bei der Messvorrichtung B um eine solche Kamera. Der Durchmesser wird durch eine (insbesondere digitale) Bildbearbeitung eines mittels der Messvorrichtung B erzeugten Bildes oder Bildausschnitts vom Reaktorinneren bestimmt. Es kann auch vorgesehen sein, ein Video zu erzeugen, wobei dann vorzugsweise Einzelbilder des Videos einer Bildbearbeitung unterzogen werden.

Die Bildbearbeitung kann durch eine analoge oder digitale Bildbearbeitungseinheit erfolgen, die vorzugsweise von der Messvorrichtung B umfasst ist. Insbesondere kann es sich um eine Computersoftware handeln. Bei der Bildbearbeitungseinheit kann es sich auch um ein separates Gerät handeln, das mit der Messvorrichtung B verbunden ist.

Die Bestimmung des Durchmessers kann erfolgen, indem der Fokus der Kamera so gewählt wird, dass zumindest ein Siliciumstab in seiner Breite vor der inneren Reaktorwand sichtbar ist. In der Regel erscheint auf dem so erhaltenen Bild der Siliciumstab hell vor der im Hintergrund dunkler erscheinenden Reaktorinnenwand. Mittels Pixelanalyse durch die Bildbearbeitungseinheit kann dann eine linke Kontur (Kante) und eine rechte Kontur (Kante) des Siliciumstabes identifiziert und die dazwischenliegende Strecke bestimmt werden. Die Kamera ist üblicherweise derart kalibriert, dass das mit ihr aufgenommene Bild in seiner Breite einer bestimmten Strecke in Umfangsrichtung auf der Reaktorinnenwand entspricht. Die Reaktorgeometrie, insbesondere der Reaktorumfang auf Höhe der Kamera, ist grundsätzlich bekannt. Die Position des Siliciumstabes und damit dessen Abstand zur Reaktorinnenwand sowie zur Kamera ist üblicherweise ebenfalls bekannt. Durch Korrelation der aus der Reaktorkonfiguration bekannten Strecken bzw. Abständen kann dann anhand der zwischen linker und rechter Kontur des Siliciumstabes liegenden Strecke der Stabdurchmesser errechnet werden. Der Fokus der Kamera kann auch so ausgewählt werden, dass mehrere, insbesondere zwei oder drei, Siliciumstäbe in ihrer vollen Breite vor der inneren Reaktorwand sichtbar sind. Das Messprinzip bleibt das gleiche.

Grundsätzlich ist es auch möglich anhand des erhaltenen Bildes, den Abstand zwischen zwei benachbarten Stäben vor der Reaktorwand zu messen und daraus deren Durchmesser, insbesondere mittels Triangulation, zu berechnen. Bei dieser Variante müssen die beiden benachbarten Stäbe nicht notwendigerweise jeweils in ihrer vollen Breite auf dem Bild erkennbar sein. Grundsätzlich müssen die rechte Kante des linken Stabes und die linke Kante des rechten Stabes erkennbar sein. Durch Korrelation der aus der Reaktorkonfiguration bekannten Strecken bzw. Abständen kann dann anhand des Abstands der Stäbe zueinander der Durchmesser berechnet werden.

Gemäß einer weiteren Ausführungsform umfasst die Messvorrichtung B eine Recheneinheit, wobei der Durchmesser aus mittels der Recheneinheit erfassten Parametern des Abscheidungsprozesses bestimmt wird.

Bei den Parametern kann es sich um einen oder mehrere Parameter aus der Gruppe mit Volumenstrom des Reaktionsgases, Abscheidetemperatur, Stabstromstärke, Stabspannung, elektrischer Stabwiderstand und Prozesszeit handeln.

Der Volumenstrom kann beispielsweise durch einen Durchflussmesser (z.B. Schwebekörper-Durchflussmesser) in einer Reaktionsgaszuleitung zum Reaktor bestimmt werden. Gegebenenfalls erfolgt die Bestimmung bevor sich die Zuleitung zu mehreren Düsen verzweigt.

Bei der Stabstromstärke handelt es sich um die Stromstärke, mit welcher die Siliciumstabpaare erhitzt werden (Joule-Erwärmung). Bei der Stabspannung handelt es sich um die Spannung, die zur Erzeugung des Stabstroms zwischen einem Stabpaar anliegt. Die Messung der Spannung und Stromstärke kann mittels handelsüblicher Messgeräte erfolgen. Bei dem elektrischen Stabwiderstand handelt es sich um den Heizwiderstand der Siliciumstäbe. Dieser wird aus der Stabspannung und der Stromstärke berechnet. Bei der Prozesszeit handelt es sich um die Zeit, die seit Beginn der Gasphasenabscheidung bereits vergangen ist.

Der oder die gemessenen Parameter werden insbesondere an die Recheneinheit weitergeleitet und von dieser erfasst, wobei mittels einer Software der Stabdurchmesser berechnet werden kann. Dazu wird üblicherweise mittels einer Kamera der Messvorrichtung B der Durchmesser zu einer bestimmten Abscheidezeit, insbesondere zu Beginn der Abscheidung, bestimmt. Mittels der oben genannten Parameter kann dann unter Verwendung von Vergleichsdaten aus vorherigen Abscheidungsprozessen mittels der Software eine Berechnung des Stabdurchmessers in Abhängigkeit der Abscheidezeit erfolgen.

Bevorzugt kann die Messvorrichtung B sowohl eine Kamera als auch eine Recheneinheit umfassen. Die Bestimmung des Stabdurchmessers kann dann anhand beider Methoden erfolgen und die erhaltenen Werte miteinander verglichen werden. Das Risiko von Messfehlern kann so minimiert werden.

Vorzugsweise wird der Durchmesser von mindestens drei oder vier Siliciumstäben bestimmt. Die verschiedenen Durchmesser können dabei von einer Kamera bestimmt werden, beispielsweise indem der Fokus der Kamera derart eingestellt wird, dass zwei oder mehr Siliciumstäbe in dem erzeugten Bild zu sehen sind (siehe Beschreibung oben).

Es können allerdings auch zwei oder mehr Kameras, die unterschiedlich um den Reaktor positioniert sind, gemäß der obigen Beschreibung den Durchmesser verschiedener Stäbe bestimmen. Vorzugsweise befinden sich dabei die Kameras auf unterschiedlicher Höhe. So ist es auch denkbar, dass zwei übereinander angeordnete Kameras den Durchmesser des oder der selben Stabs/Stäbe, allerdings in unterschiedlicher Höhe bestimmen. Aus den ermittelten Werten für den Durchmesser kann dann ein Mittelwert gebildet werden, wodurch sich die Messgenauigkeit zusätzlich erhöhen lässt.

Gemäß einer weiteren Ausführungsform umfasst die Messvorrichtung A ein Thermographiesystem, insbesondere Pyrometer oder Wärmebildkamera. Vorzugsweise handelt es sich bei der Messvorrichtung A um zumindest ein solches Thermographiesystem.

Die Messvorrichtung A wird vorzugsweise derart positioniert, dass die vertikal verlaufenden Kanten des Siliciumstabes, dessen Oberflächentemperatur bestimmt werden soll, am Ende des Abscheidungsprozesses nicht außerhalb des Fokusbereichs liegen. Der Fokus der Messvorrichtung A ist vorzugsweise auf den Siliciumstab gerichtet, welcher der Messvorrichtung A am nächsten ist. Üblicherweise handelt es sich dabei um den Siliciumstab, welcher dem Sichtfenster, vor dem die Messvorrichtung A positioniert ist, am nächsten ist. Generell spielt die Position des Sichtfensters bzw. die Position des Stabes im Reaktor für die Ausführung der Erfindung wie oben bereits beschrieben keine Rolle.

Üblicherweise ist zu Beginn des Abscheidungsprozesses, die Messvorrichtung A derart kalibriert, dass ihre Messfläche in ihrer Breite an den Durchmesser der verwendeten Filamentstäbe angepasst ist. Vorzugsweise ist die Messfläche zu Beginn im Bereich der Stabmitte positioniert.

Die Messvorrichtung A kann auch eine Bildbearbeitungseinheit zur digitalen oder analogen Bildbearbeitung umfassen. Die Position der Messfläche kann so beispielsweise durch eine Pixelanalyse und Erkennung der linken Kontur (Kante) und rechten Kontur (Kante) des Siliciumstabes kontrolliert werden. Diesbezüglich kann auf die Ausführungen zur Messvorrichtung B verwiesen werden.

Die Anpassung der Messfläche an die mit fortschreitender Prozessdauer im Durchmesser wachsenden Stäbe erfolgt auf Basis des mittels der Messvorrichtung B bestimmten Stabdurchmessers entweder kontinuierlich oder diskontinuierlich. Bevorzugt geschieht dies durch eine Rückkopplung, bei der vor jeder Bestimmung der Oberflächentemperatur in der Messfläche der Durchmesser von der Messvorrichtung B abgefragt werden kann. Vorzugsweise sind die Messvorrichtungen A und B dazu miteinander gekoppelt, insbesondere über einen Controller. Über den Controller können beispielsweise bei einer diskontinuierlichen Anpassung der Messfläche die Zeitintervalle eingestellt werden. Ferner kann die Geometrie der Messfläche und/oder der Grad der Ausdehnung der Messfläche in Abhängigkeit des Durchmessers eingestellt werden.

Die Messfläche weist vorzugsweise eine senkrecht zu einer Siliciumstabachse verlaufende Breite auf, wobei die Messfläche derart in Abhängigkeit des Stabdurchmessers definiert wird, dass die Breite zwischen 2 und 98%, bevorzugt 5 und 95%, besonders bevorzugt 10 und 90%, des Durchmessers beträgt. Durch die bevorzugt mittige (zwischen den vertikal verlaufenden Kanten des Siliciumstabes) Positionierung der Messfläche werden auf diese Weise die Randbereiche des Siliciumstabes bei der Temperaturerfassung ausgespart. Dies erhöht die Genauigkeit der Messung, da die Wärmestrahlung in diesen Bereichen grundsätzlich nur zu einem kleinen Teil von einem Detektor des Thermographiesystems erfasst werden kann.

Bevorzugt weist die Messfläche eine parallel zur Siliciumstabachse verlaufende Höhe auf, wobei die Messfläche derart angepasst wird, dass die Höhe zwischen 2 und 300%, bevorzugt 5 und 200%, besonders bevorzugt 10 und 150%, des Durchmessers beträgt. Die Höhe der Messfläche kann auch konstant gehalten werden. Vorzugsweise nimmt die Höhe der Messfläche in demselben Maß zu wie ihre Breite.

Vorzugsweise ist die Messfläche rechteckig ausgebildet. Die Messfläche kann auch eine andere Form aufweisen. Beispielsweise kann es sich um einen Kreis handeln. Dieser kann dann mit zunehmendem Stabdurchmesser größer werden oder es bildet sich mit fortschreitender Dauer der Abscheidung eine ovale Messfläche, beispielsweise dann, wenn die Höhe konstant gehalten wird.

Die Bestimmung der Oberflächentemperatur und eine Bestimmung des Durchmessers kann an demselben Siliciumstab erfolgen.

Bevorzugt können auch zwei oder mehr Messvorrichtungen A die Oberflächentemperatur an verschiedenen Siliciumstäben messen.

Gemäß einer weiteren Ausführungsform wird eine Abscheidetemperatur anhand der bestimmten Oberflächentemperatur in der Messfläche gesteuert. Bei der Abscheidetemperatur handelt es sich um einen Sollwert der Oberflächentemperatur, der zu einem bestimmten Zeitpunkt während des Abscheidungsprozesses idealerweise erreicht sein soll. Die Abscheidetemperatur liegt in der Regel zwischen 900 und 1200°C und kann während des Abscheideprozesses variiert werden, beispielsweise um die Oberflächenbeschaffenheit der Siliciumstäbe zu beeinflussen. Vor diesem Hintergrund ist es wichtig, über eine Methode zur Oberflächentemperaturmessung zu verfügen, bei der oberflächenbedingte Extremwerte das Messergebnis nicht verfälschen. Das erfindungsgemäße Verfahren stellt eine solche Methode dar.

Alternativ oder zusätzlich können auch weitere Parameter in Abhängigkeit von der gemessenen Oberflächentemperatur gesteuert werden, beispielsweise Volumenstrom des Reaktionsgases, Stabstromstärke, Stabspannung, elektrischer Stabwiderstand.

Gemäß einer weiteren Ausführungsform wird der Abscheideprozess nach dem Erreichen eines vorgegebenen Stabdurchmessers beendet.

Ferner beschrieben ist eine Anordnung zur Bestimmung einer Oberflächentemperatur von mindestens einem Siliciumstab in einem chemischen Gasphasenabscheidungsreaktor während eines Abscheidungsprozesses, umfassend eine Messvorrichtung B zur Bestimmung des Durchmessers von mindestens zwei Siliciumstäben und eine mit der Messvorrichtung B gekoppelte Messvorrichtung A zur Bestimmung der Oberflächentemperatur innerhalb einer, vorzugsweise mittig, auf dem Siliciumstab angeordneten Messfläche, wobei die Größe und/oder die Position der Messfläche in Abhängigkeit des oder der ermittelten Durchmesser angepasst wird, und wobei die Messvorrichtungen A und B an verschiedenen Positionen jeweils vor einem von der Anordnung umfassten Sichtfenster im Reaktormantel außerhalb des Reaktors angeordnet sind.

Insbesondere eignet sich die Anordnung zur Durchführung des zuvor beschrieben Verfahrens. Hinsichtlich der Ausgestaltung der Anordnung kann daher auch auf die obigen Ausführungen verwiesen werden.

Die Messvorrichtungen A und B können jeweils schwenkbar, insbesondere senkrecht zur vertikal verlaufenden Siliciumstabachse, gelagert sein.

Vorzugsweise sind die Messvorrichtungen A und B über einen Controller miteinander gekoppelt. Bei dem Controller kann es sich beispielsweise um eine computergestützte Software handeln. Der Controller ist vorzugsweise von der Anordnung umfasst.

Ferner kann die Anordnung zumindest eine analoge oder digitale Bildbearbeitungseinheit umfassen. Die Bildbearbeitungseinheit kann sowohl mit der Messvorrichtung A als auch mit der Messvorrichtung B verbunden sein oder jede der Messvorrichtungen A und B ist jeweils mit einer solchen Bildbearbeitungseinheit verbunden.

Der Controller zur dynamischen Anpassung der Messfläche und die Bildbearbeitungseinheit sind in einem System, beispielsweise Software, zusammengefasst. Das System ist Bestandteil der Anordnung. Besonders bevorzugt kann ein solches System ferner die Recheneinheit zur parametergestützten Durchmesserbestimmung umfassen.

Insbesondere handelt es sich bei dem System um einen softwaregestützten Prozessleitstand.

Für eine möglichst fehlerfreie und reproduzierbare Temperaturmessung in der Messfläche ist ein homogener und störungsfreier optischer Weg wichtig. Es ist vorteilhaft, wenn das Sichtfenster und gegebenenfalls sämtliche darin verbauten optischen Elemente eine konstante optische Transmission aufweisen. Ferner sollte verhindert werden, dass sich Ablagerungen an den Flächen des Sichtfensters und seiner Komponenten niederschlagen, insbesondere an der Reaktorinnenseite zugewandten Flächen. Durch die hohen Temperaturen, die eingeleiteten Gase und Flüssigkeiten während der Abscheidung können sich ferner die optischen Eigenschaften des Sichtfensters und seiner Komponenten verändern (Änderung der optischen Transmission).

Vorzugsweise umfasst das Sichtfenster ein erstes und ein zweites optisches Element, wobei die optischen Elemente durch einen mit einem Kühlmedium gefüllten Raum voneinander beabstandet sind. Das erste optische Element ist vorzugsweise der Messvorrichtung zugewandt, während das zweite optische Element dem Reaktorinneren zugewandt ist. Die Temperaturdrifts lassen sich durch die Kühlung minimieren. Bei den optischen Elementen handelt es sich vorzugsweise um Scheiben aus Glas oder Quarzglas. Bevorzugt bestehen beide optischen Elemente aus demselben Material.

Bei dem Kühlmedium kann es sich um eine Flüssigkeit, insbesondere Wasser, oder um ein Gas (z.B. H₂ oder N₂) handeln. Vorzugsweise hat der Raum einen Einlass und einen Auslass für das Kühlmedium, damit die Temperatur der optischen Elemente durch einen vorzugsweise kontinuierlichen Kühlmediumstrom konstant gehalten werden kann.

Vorzugsweise wird eine ins Reaktorinnere gerichtete Oberfläche des zweiten optischen Elements derart mit einem Gas, vorzugsweise Wasserstoff, beaufschlagt, dass ein Kontakt mit sich im Reaktorinneren befindlichen Gasen unterbunden ist. Hierzu können eine oder mehrere Düsen auf die ins Reaktorinnere gerichtete Oberfläche gerichtet sein, die unter einem bestimmten Druck die Oberfläche kontinuierlich oder in bestimmten Zeitabständen abblasen. Die Düse(n) kann/können auch parallel zur Oberfläche ausgerichtet sein, so dass sich bei einem kontinuierlichen Gasstrom eine Art Schutzschicht vor der ins Reaktorinnere gerichteten Oberfläche des zweiten optischen Elements ausbildet. Alternativ oder zusätzlich kann zumindest eine Düse vorgesehen sein, die der Oberfläche entgegengesetzt ausgerichtet ist und durch einen kontinuierlichen Gasstrom das aus dem Reaktorinnenraum herantretende Gas verdrängt.

Ein weiterer Aspekt der Erfindung betrifft einen Gasphasenabscheidungsreaktor zur Abscheidung von polykristallinem Silicium, umfassend eine metallische Grundplatte, einen lösbaren auf der Grundplatte angeordneten glockenförmigen und kühlbaren Reaktormantel, der einen Reaktorinnenraum einschließt, Düsen zur Gaszufuhr und Öffnungen zur Abfuhr von Reaktionsgas, Elektrodenhalterungen für Filamentstäbe sowie die zuvor beschriebene Anordnung. Der Reaktor eignet sich insbesondere zur Durchführung des erfindungsgemäßen Verfahrens.
- **Fig. 1**: zeigt schematisch die Anordnung zur Durchführung des erfindungsgemäßen Verfahrens.
- **Fig. 2**: zeigt die auf einem Siliciumstab angeordnete dynamische Messfläche.
- **Fig. 3**: zeigt den Bereich des Sichtfensters der Anordnung zur Durchführung des erfindungsgemäßen Verfahrens.

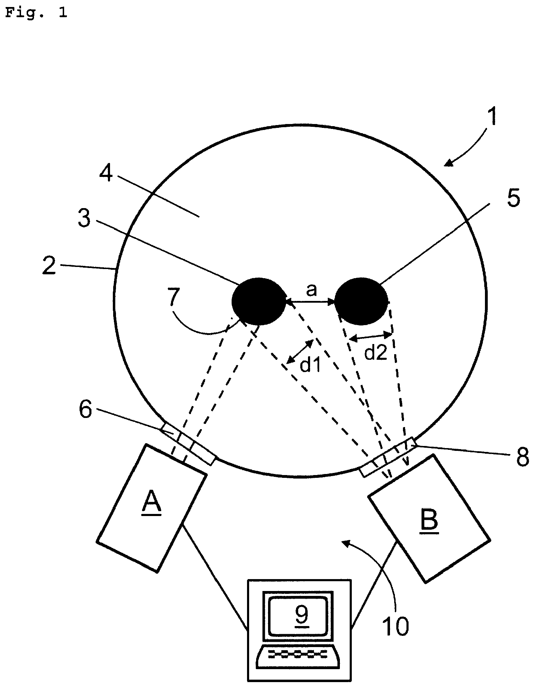

Fig. 1 zeigt eine schematische Querschnittsdarstellung eines Siemens-Reaktors 1, der eine Anordnung 10 zur Bestimmung der Oberflächentemperatur eines Siliciumstabes 3 umfasst. Der Reaktor 1 umfasst einen Mantel 2, der einen Reaktorinnenraum 4 einschließt. Auf die Darstellung eines Kühlsystems des Reaktormantels 2 wurde verzichtet. In dem Mantel 2 sind auf gleicher Höhe zwei Sichtfenster 6, 8 angeordnet. Vor dem Sichtfenster 6 befindet sich eine Messvorrichtung A, bei der sich um ein Pyrometer handelt. Vor dem Sichtfenster 8 befindet sich eine Messvorrichtung B, bei der es sich um eine Digitalkamera handelt. Beide Messvorrichtungen A und B sind ferner mit einem System 9 gekoppelt, das eine Bildbearbeitungseinheit, einen Controller zur dynamischen Anpassung einer Temperaturmessfläche 7 und eine Recheneinheit zur prozessparametergestützten Durchmesserbestimmung enthält. Bei dem System 9 handelt es sich um einen softwaregestützten Prozessleitstand. Die Messvorrichtungen A und B, die Sichtfenster 6, 8 sowie das System 9 bilden die Anordnung 10.

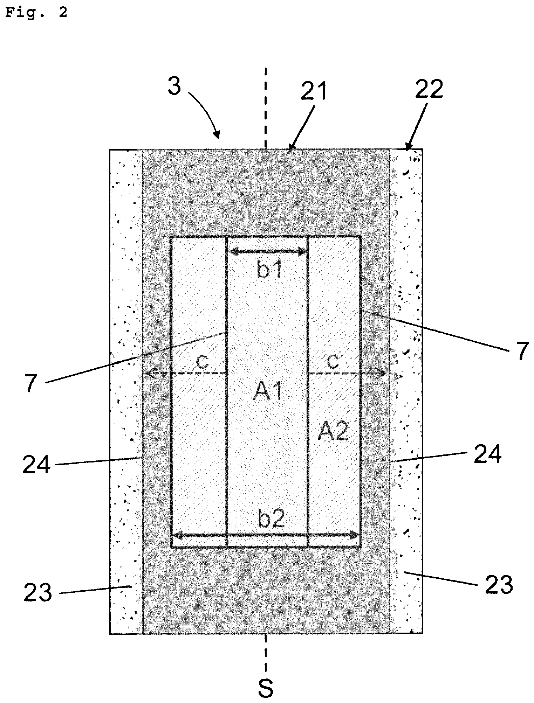

Zur Bestimmung der Oberflächentemperatur in der Messfläche 7 auf einem Siliciumstab 3 mittels der Messvorrichtung A wird zunächst mittels der Messvorrichtung B der Durchmesser zweier Siliciumstäbe 3, 5 ermittelt. Dazu nimmt die Messvorrichtung B ein Bild des Reaktorinnenraumes 4 auf, wobei der Fokus der Kamera so eingestellt ist, dass beide Siliciumstäbe 3, 5 erkennbar sind. Die Messvorrichtung B kann gegebenenfalls auch schwenkbar angeordnet sein und je ein Bild der Siliciumstäbe 3, 5 aufnehmen. Das oder die erhaltenen Bilder werden an das System 9 übermittelt und mittels der integrierten Bildbearbeitungseinheit die Konturen (linke und rechte Kanten, angedeutet durch vier gestrichelte Linien) der Siliciumstäbe 3, 5 ermittelt. Anhand der zwischen der linken und der rechten Kante liegenden Strecke auf dem Bild lassen sich wie oben beschrieben die Durchmesser d1 und d2 der Siliciumstäbe 3, 5 berechnen. Alternativ oder zusätzlich können die Durchmesser d1 und d2 auch über den Abstand a der Siliciumstäbe 3, 5 zueinander berechnet werden (siehe Beschreibung oben). Gegebenenfalls erfolgt die Bestimmung weiterer Stabdurchmesser an anderen Siliciumstäben. Aus den erhaltenen Werten wird ein Mittelwert gebildet, der an den Controller weitergereicht wird. Der Controller bewirkt dann eine Anpassung der Messfläche 7 des Pyrometers an den erhalten Wert, indem er die Breite der Messfläche (angedeutet durch zwei gestrichelte Linien) vergrößert wie aus Fig. 2 ersichtlich ist.

Fig. 2 zeigt einen Ausschnitt aus zwei thermographischen Aufnahmen 21, 22 eines Abschnitts eines Siliciumstabes 3, die übereinandergelegt und mit der Messvorrichtung A (Pyrometer) aufgenommen wurden. Die Aufnahme 21 ist in etwa zur Hälfte der gesamten Abscheidezeit entstanden. Die Aufnahme 22 ist kurz vor Beendigung der Abscheidung entstanden. Die helleren Bereiche 23 entsprechen dem Zuwachs an Polysilicium der zwischen beiden Aufnahmen 21, 22 stattgefunden hat. Die Fläche A1 entspricht der zu Beginn der Abscheidung definierten Messfläche 7 zur Bestimmung der Oberflächentemperatur des Siliciumstabes 3. Die im Wesentlichen senkrecht zu einer Stabachse S verlaufende Breite b1 der Messfläche 7 betrug zu diesem Zeitpunkt etwa 90% der Breite (Durchmesser) des Siliciumstabes 3. Die Fläche A2 entspricht der Messfläche 7 zum Zeitpunkt der Aufnahme 21. Dessen Breite b2 betrug zu diesem Zeitpunkt etwa 80% der Breite (Durchmesser) des Siliciumstabes 3. Die mit c gekennzeichneten gestrichelten Pfeile deuten die kontinuierliche Anpassung der Messflächenbreite über die Abscheidezeit in Abhängigkeit des Stabdurchmessers an. Diese Anpassung erfolgt durch die kontinuierliche Bestimmung eines oder mehrerer Stabdurchmesser mittels der Messvorrichtung B (vgl. Fig. 1). Die Position der Messfläche 7 wurde derart angepasst, dass sie in der Mitte des ermittelten Stabdurchmessers liegt. Die Höhe der Messfläche 7 war konstant.

Es ist gut erkennbar, dass die Breite b2 der Messfläche 7 nur etwa 80% des Stabdurchmessers beträgt. Ferner ist die Messfläche 7 mittig angeordnet, sodass die Bereiche in Nähe der Stabkanten 24 von der Temperaturmessung ausgespart bleiben. Die von der Staboberfläche emittierte Wärmestrahlung in diesen Randbereichen kann nicht mehr ausreichend durch den Detektor eines Pyrometers erfasst werden und würde das Messergebnis verfälschen.

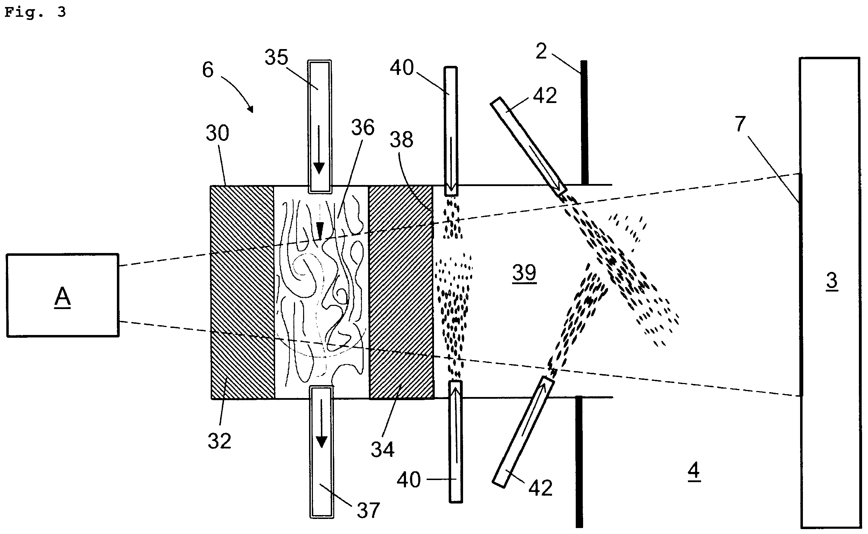

Fig. 3 zeigt eine detailliertere Darstellung des Sichtfensters 6 aus der Fig. 1. Das Sichtfenster 6 umfasst ein erstes optisches Element 32 und ein zweites optisches Element 34, die in einem Tubus 30 angeordnet sind. Der Tubus 30 ist mit dem Reaktormantel 2 verbunden und besteht vorzugsweise aus demselben Material wie dieser. Die optischen Elemente 32, 34 sind aus Quarzglas. Zwischen ihnen befindet sich ein Raum 36, der mit einer Zugasleitung 35 und einer Abgasleitung 37 versehen ist. Zur Kühlung der optischen Elemente 32, 34 wird der Raum 36 kontinuierlich mit N₂ oder H₂ durchströmt. Das optische Element 34 hat eine dem Reaktorinneren 4 zugewandte Seite 38. Parallel zu dieser Seite 38 sind einander gegenüberliegend zwei Düsen 40 angeordnet, welche in einen Bereich 39 vor der Seite 38 Wasserstoffgas einblasen. Auf diese Weise wird zum einen die Seite 38 gekühlt und zum anderen eine Kontaktierung durch siliciumhaltige Reaktionsgase oder Partikel aus dem Reaktorinneren 4 unterbunden. Gegebenenfalls vorhandene Ablagerungen können ebenfalls abgeblasen werden, wozu die Düsen 40 auch drehbar angeordnet sein können. Ferner sind weitere Düsen 42 vorgesehen, die schräg in Richtung Reaktorinnenraum 4 ausgerichtet sind und ebenfalls Wasserstoffgas in den Bereich 39 einblasen. Auf diese Weise wird ein Kontakt der Seite 38 mit Komponenten aus dem Reaktorinnenraum 4 zusätzlich erschwert.

## Patentansprüche

1. Verfahren zur Bestimmung einer Oberflächentemperatur von mindestens einem Siliciumstab in einem chemischen Gasphasenabscheidungsreaktor, enthaltend mehrere Siliciumstäbe, während eines Abscheidungsprozesses, bei dem eine Messvorrichtung A in einer auf dem Siliciumstab angeordneten Messfläche die Oberflächentemperatur bestimmt und eine separate Messvorrichtung B kontinuierlich oder diskontinuierlich mindestens einen Durchmesser des Siliciumstabes und mindestens einen Durchmesser zumindest eines anderen in dem Reaktor angeordneten Siliciumstabes ermittelt, wobei die Messvorrichtungen A und B an verschiedenen Positionen jeweils vor einem Sichtfenster oder vor einem gemeinsamen Sichtfenster außerhalb des Reaktors angeordnet sind und wobei die Größe und/oder die Position der Messfläche in Abhängigkeit des oder der ermittelten Durchmesser angepasst wird.

2. Verfahren nach Anspruch 1, umfassend die Schritte
a) Ermitteln von jeweils mindestens einem Durchmesser des Siliciumstabes und von zumindest einem anderen Siliciumstab mit der Messvorrichtung B;
b) Definieren der Größe und/oder der Position der auf dem Siliciumstab angeordneten Messfläche in Abhängigkeit des in Schritt a) ermittelten Durchmessers;
c) Bestimmen der Oberflächentemperatur innerhalb der Messfläche mit der Messvorrichtung A;
d) Kontinuierliches oder diskontinuierliches Wiederholen der Schritte a), b) und c), wobei eine kontinuierliche oder diskontinuierliche Anpassung der Größe und/oder der Position der Messfläche an den Durchmesser des Siliciumstabes erfolgt.

3. Verfahren nach Anspruch 1 oder 2, **dadurch gekennzeichnet, dass** die Messvorrichtung B eine Kamera umfasst, wobei der Durchmesser durch Bildbearbeitung eines mittels der Kamera erzeugten Bildes vom Reaktorinneren bestimmt wird.

4. Verfahren nach einem der vorhergehenden Ansprüche, **dadurch gekennzeichnet, dass** die Messvorrichtung B eine Recheneinheit umfasst, wobei der Durchmesser aus mittels der Recheneinheit erfassten Prozessparametern des Abscheidungsprozesses bestimmt wird.

5. Verfahren nach einem der vorhergehenden Ansprüche, **dadurch gekennzeichnet, dass** der Durchmesser von mindestens drei Siliciumstäben bestimmt wird.

6. Verfahren nach einem der vorhergehenden Ansprüche, **dadurch gekennzeichnet, dass** die Messvorrichtung A ein Thermographiesystem, insbesondere Pyrometer oder Wärmebildkamera, umfasst.

7. Verfahren nach einem der vorhergehenden Ansprüche, **dadurch gekennzeichnet, dass** die Messfläche eine senkrecht zu einer Siliciumstabachse verlaufende Breite aufweist, wobei die Messfläche derart definiert wird, dass die Breite zwischen 2 und 98%, bevorzugt 5 und 95%, besonders bevorzugt 10 und 90%, des Durchmessers beträgt.

8. Verfahren nach Anspruch 7, **dadurch gekennzeichnet, dass** die Messfläche eine parallel zur Siliciumstabachse verlaufende Höhe aufweist, wobei die Messfläche derart definiert wird, dass die Höhe zwischen 2 und 300%, bevorzugt 5 und 200%, besonders bevorzugt 10 und 150%, des Durchmessers beträgt oder konstant ist.

9. Verfahren nach einem der vorhergehenden Ansprüche, **dadurch gekennzeichnet, dass** die Messfläche rechteckig ist.

10. Verfahren nach einem der vorhergehenden Ansprüche, **dadurch gekennzeichnet, dass** eine Abscheidetemperatur auf Basis der Oberflächentemperatur gesteuert wird.

11. Verfahren nach einem der vorhergehenden Ansprüche, **dadurch gekennzeichnet, dass** der Abscheideprozess nach dem Erreichen eines vorgegebenen Durchmessers beendet wird.

12. Reaktor zur Abscheidung von polykristallinem Silicium, umfassend eine metallische Grundplatte, einen lösbaren auf der Grundplatte angeordneten glockenförmigen und kühlbaren Reaktormantel, der einen Reaktorinnenraum einschließt, Düsen zur Gaszufuhr und Öffnungen zur Abfuhr von Reaktionsgas, Elektrodenhalterungen für Filamentstäbe sowie eine Anordnung zur Bestimmung einer Oberflächentemperatur von mindestens einem Siliciumstab, wobei die Anordnung umfasst
- eine Messvorrichtung B zur Bestimmung des Durchmessers von mindestens zwei im Reaktorinnenraum angeordneten Siliciumstäben;
- eine mit der Messvorrichtung B gekoppelte Messvorrichtung A zur Bestimmung der Oberflächentemperatur innerhalb einer auf dem Siliciumstab angeordneten Messfläche,
- zumindest ein Sichtfenster im Reaktormantel,
- ein System, mit dem die Messvorrichtungen A und B gekoppelt sind,
wobei die Messvorrichtungen A und B an verschiedenen Positionen jeweils vor einem Sichtfenster oder vor einem gemeinsamen Sichtfenster außerhalb des Reaktors angeordnet sind.

13. Reaktor nach Anspruch 12, **dadurch gekennzeichnet, dass** das Sichtfenster ein erstes und ein zweites optisches Element umfasst, wobei die optischen Elemente durch einen mit einem Kühlmedium gefüllten Raum voneinander beabstandet sind.

14. Reaktor nach Anspruch 13, **dadurch gekennzeichnet, dass** eine ins Reaktorinnere gerichtete Oberfläche des zweiten optischen Elements mit einem Gas beaufschlagbar ist.

15. Reaktor nach einem der Ansprüche 12 bis 14, **dadurch gekennzeichnet, dass** es sich bei dem System um einen softwaregestützten Prozessleitstand handelt.

## Claims

1. Method for determining a surface temperature of at least one silicon rod in a chemical vapour deposition reactor, containing a plurality of silicon rods, during a deposition process, wherein a measuring apparatus A determines the surface temperature in a measuring area disposed on the silicon rod, and a separate measuring apparatus B continuously or discontinuously ascertains at least one diameter of the silicon rod and at least one diameter of at least one other silicon rod disposed in the reactor, the measuring apparatuses A and B being disposed at different positions in each case in front of a viewing window or in front of a joint viewing window outside the reactor, and the size and/or the position of the measuring area being adapted in dependence on the diameter or diameters ascertained.

2. Method according to Claim 1, comprising the steps of
a) ascertaining in each case at least one diameter of the silicon rod and of at least one other silicon rod with the measuring apparatus B;
b) defining the size and/or the position of the measuring area disposed on the silicon rod, in dependence on the diameter ascertained in step a) ;
c) determining the surface temperature within the measuring area with the measuring apparatus A;
d) continuously or discontinuously repeating steps a), b) and c), with continuous or discontinuous adaptation of the size and/or the position of the measuring area to the diameter of the silicon rod.

3. Method according to Claim 1 or 2, **characterized in that** the measuring apparatus B comprises a camera, the diameter being determined by image processing of an image of the reactor interior that is generated by means of the camera.

4. Method according to any of the preceding claims, **characterized in that** the measuring apparatus B comprises an arithmetic unit, the diameter being determined from process parameters of the deposition process that are captured by means of the arithmetic unit.

5. Method according to any of the preceding claims, **characterized in that** the diameter of at least three silicon rods is determined.

6. Method according to any of the preceding claims, **characterized in that** the measuring apparatus A comprises a thermography system, in particular pyrometer or thermal imaging camera.

7. Method according to any of the preceding claims, **characterized in that** the measuring area has a width running perpendicularly to a silicon rod axis, the measuring area being defined such that the width is between 2 and 98%, preferably 5 and 95%, more preferably 10 and 90%, of the diameter.

8. Method according to Claim 7, **characterized in that** the measuring area has a height running parallel to the silicon rod axis, the measuring area being defined such that the height is between 2 and 300%, preferably 5 and 200%, more preferably 10 and 150%, of the diameter or is constant.

9. Method according to any of the preceding claims, **characterized in that** the measuring area is rectangular.

10. Method according to any of the preceding claims, **characterized in that** a deposition temperature is controlled on the basis of the surface temperature.

11. Method according to any of the preceding claims, **characterized in that** the deposition process is ended on attainment of a stipulated diameter.

12. Reactor for depositing polycrystalline silicon, comprising a metallic baseplate, a separable and coolable, bell-shaped reactor shell disposed on the baseplate and enclosing a reactor interior, nozzles for the supply of gas and openings for the removal of reaction gas, electrode mounts for filament rods, and an arrangement for determining a surface temperature of at least one silicon rod, the arrangement comprising
- a measuring apparatus B for determining the diameter of at least two silicon rods disposed in the reactor interior;
- a measuring apparatus A, coupled with the measuring apparatus B, for determining the surface temperature within a measuring area disposed on the silicon rod,
- at least one viewing window in the reactor shell,
- a system with which the measuring apparatuses A and B are coupled,
the measuring apparatuses A and B being disposed at different positions in each case in front of a viewing window or in front of a joint viewing window outside the reactor.

13. Reactor according to Claim 12, **characterized in that** the viewing window comprises first and second optical elements, the optical elements being spaced apart from one another by a chamber filled with a cooling medium.

14. Reactor according to Claim 13, **characterized in that** a surface of the second optical element that is directed into the reactor interior can be charged with a gas.

15. Reactor according to any of Claims 12 to 14, **characterized in that** the system is a softwareassisted process control station.

## Revendications

1. Procédé de détermination d'une température de surface d'au moins un barreau de silicium dans un réacteur de dépôt chimique en phase vapeur, contenant plusieurs barreaux de silicium, au cours d'un processus de dépôt dans lequel un dispositif de mesure A détermine la température de surface dans une surface de mesure disposée sur le barreau de silicium et un dispositif de mesure séparé B détermine de manière continue ou discontinue au moins un diamètre du barreau de silicium et au moins un diamètre d'au moins un autre barreau de silicium disposé dans le réacteur, les dispositifs de mesure A et B étant disposés à des positions différentes devant une fenêtre d'observation ou devant une fenêtre d'observation commune à l'extérieur du réacteur, et la dimension et/ou la position de la surface de mesure étant adaptées en fonction du ou des diamètres déterminés.

2. Procédé selon la revendication 1, comprenant les étapes suivantes
a) déterminer à chaque fois au moins un diamètre du barreau de silicium et d'au moins un autre barreau de silicium à l'aide du dispositif de mesure B ;
b) définir la dimension et/ou la position de la surface de mesure, disposée sur le barreau de silicium, en fonction du diamètre déterminé à l'étape a) ;
c) déterminer la température de surface à l'intérieur de la surface de mesure à l'aide du dispositif de mesure A ;
d) répéter de manière continue ou discontinue les étapes a), b) et c), une adaptation continue ou discontinue de la dimension et/ou de la position de la surface de mesure au diamètre du barreau de silicium étant effectuée.

3. Procédé selon la revendication 1 ou 2, **caractérisé en ce que** le dispositif de mesure B comprend une caméra, le diamètre étant déterminé par traitement d'une image, générée par la caméra, depuis l'intérieur du réacteur.

4. Procédé selon l'une des revendications précédentes, **caractérisé en ce que** le dispositif de mesure B comprend une unité de calcul, le diamètre étant déterminé à partir de paramètres du processus de dépôt détectés au moyen de l'unité de calcul.

5. Procédé selon l'une des revendications précédentes, **caractérisé en ce que** le diamètre d'au moins trois barreaux de silicium est déterminé.

6. Procédé selon l'une des revendications précédentes, **caractérisé en ce que** le dispositif de mesure A comprend un système de thermographie, notamment un pyromètre ou une caméra thermique.

7. Procédé selon l'une des revendications précédentes, **caractérisé en ce que** la surface de mesure a une largeur qui s'étend perpendiculairement à un axe de barreau de silicium, la surface de mesure étant définie de manière à ce que la largeur soit comprise entre 2 et 98 %, de préférence 5 et 95 %, de manière particulièrement préférée 10 et 90 %, du diamètre.

8. Procédé selon la revendication 7, **caractérisé en ce que** la surface de mesure a une hauteur parallèle à l'axe du barreau de silicium, la surface de mesure étant définie de manière à ce que la hauteur soit comprise entre 2 et 300 %, de préférence 5 et 200 %, de manière particulièrement préférée 10 et 150 %, du diamètre ou soit constante.

9. Procédé selon l'une des revendications précédentes, **caractérisé en ce que** la surface de mesure est rectangulaire.

10. Procédé selon l'une des revendications précédentes, **caractérisé en ce qu'**une température de dépôt est commandée en fonction de la température de surface.

11. Procédé selon l'une des revendications précédentes, **caractérisé en ce que** le processus de dépôt est terminé une fois qu'un diamètre spécifié est atteint.

12. Réacteur destiné au dépôt de silicium polycristallin, ledit réacteur comprenant une plaque de base métallique, une chemise de réacteur en forme de cloche amovible, qui est disposée sur la plaque de base, qui peut être refroidie et qui renferme un espace de réacteur intérieur, des buses d'alimentation en gaz et des ouvertures d'évacuation de gaz de réaction, des porte-électrodes destinées à des barreaux de filament et un ensemble de détermination d'une température de surface d'au moins un barreau de silicium, l'ensemble comprenant
- un dispositif de mesure B destiné à déterminer le diamètre d'au moins deux barreaux de silicium disposés dans l'espace de réacteur intérieur ;
- un dispositif de mesure A couplé au dispositif de mesure B et destiné à déterminer la température de surface à l'intérieur d'une surface de mesure disposée sur le barreau de silicium,
- au moins une fenêtre d'observation ménagée dans la chemise du réacteur,
- un système auquel sont couplés les dispositifs de mesure A et B,
les dispositifs de mesure A et B étant disposés à des positions différentes devant une fenêtre d'observation ou devant une fenêtre d'observation commune ménagée à l'extérieur du réacteur.

13. Réacteur selon la revendication 12, **caractérisé en ce que** la fenêtre d'observation comprend un premier et un deuxième élément optique, les éléments optiques étant espacés les uns des autres par un espace rempli d'un milieu de refroidissement.

14. Réacteur selon la revendication 13, **caractérisé en ce qu'**une surface du deuxième élément optique, dirigée vers l'intérieur du réacteur, peut être soumise à un gaz.

15. Réacteur selon l'une des revendications 12 à 14, **caractérisé en ce que** le système est un poste de conduite de processus assisté par logiciel.
